# EUROPEAN PATENT APPLICATION

(11) **EP 1 857 876 A1**
(43) Date of publication of application: **21.11.2007**
(21) Application number: 06113940.8
(22) Date of filing: 15.05.2006
(51) Int. Cl.: G03F 1/00, G03F 1/14

(54) **Method of forming a phase shift mask**

(71) Applicant: Advanced Mask Technology Center GmbH & Co. KG, 01109 Dresden (DE)
(72) Inventor: Holfeld, Christian, 01159, Dresden (DE)
(74) Representative: Kottmann, Heinz Dieter

(57) **Abstract**

The present invention refers to a method of forming a phase shift mask. In particular, the method comprises the steps of forming an absorber layer (2) on a substrate (1), forming a protective layer (3) on the absorber layer (2), forming and patterning a first mask structure (4) on the protective layer (3), transferring the pattern of the first mask structure (4) to the protective layer (3) and the absorber layer (2) by removing respective parts of the protective layer (3) and the absorber layer (2), thereby uncovering at least part of the substrate (1) by respective absorber layer openings, removing the first mask structure (4), forming and patterning a second mask structure (5) on a surface of the at least partly uncovered substrate (1), forming substrate openings (6) in regions that are not covered by the second mask structure (5) and/or the stack of the absorber layer (2) and the protective layer (3) by removing respective parts of the substrate (1), and removing said second mask structure (5) and said protective layer (3).

## Description

The present invention relates to a method of forming a phase shift mask as well as to an alternating phase shift mask fabricated therewith. The present invention further relates to a blank for fabricating a phase shift mask.

One of the main goals in semiconductor industry is the enhancement of resolution in lithography to decrease the minimum feature size of semiconductor devices such as MOSFETs (Metal Oxide Semiconductor Field Effect Transistors). In order to further improve the resolution in lithography, besides the reduction of the exposure wavelength, it is common practice to use so-called resolution enhancement techniques (RET). One out of a variety of such techniques involves phase shift masks. Phase shift masks utilize the interference, generated by phase differences of light. When the phase of certain areas of the spatial light modulation by a reticle is shifted with respect to other areas by e.g. 180°, the interference of light at the boundary between such areas sharpens the tails of the intensity envelope to enhance contrast and resolution. Beside resolution enhancement, there is a variety of mask layout patterns used e.g. for monitoring the defocus during wafer exposures or the aberrations of the optics which apply a phase difference between certain mask areas of 180° or other than 180°.

Several types of phase shift masks are known and these types can be distinguished by the number of patterning steps to fabricate the respective masks, for example. Attenuated phase shift masks or chromeless phase shift lithography masks require a single patterning process, whereas alternating phase shift masks require more than a single patterning step to define areas of a different phase shift during wafer lithography. Typically, the pattern is transferred to the alternating phase shift mask with two different writing steps and subsequent etching steps. In a first patterning step an absorber layer on the mask is patterned, thereby providing absorber layer openings. However, up to now, no phase shift exists between light traversing different absorber layer openings. Therefore, a second patterning step is used to introduce openings into the next layer(s) of a substrate, wherein a first part of the absorber layer openings is covered by a patterning mask and a second part is not. Thus, substrate openings are merely formed congruent with the second part of the absorber layer openings. Thereby a phase shift is introduced between light passing the substrate, said substrate openings and the second part of absorber layer openings compared to light merely passing the substrate and the first part of absorber layer openings. This phase shift is ascribable to an optical retardation.

The inventor has found out that the homogeneity of the absorber layers after mask fabrication may not be suited for future generations of phase shift masks. Homogeneity of the absorber layer is of importance as inhomogeneities may come up as defects during mask pattern inspection or may cause spatial variations of the absorber properties in wafer lithography due to variation of absorption of the lithographically dark feature resulting in a more difficult control of the lithographic process. These influences aggravate with further down-scaling. Although defects due to inhomogeneous absorber structures may be disregarded by human judgement, the high number of automatic defect counts expected during mask inspection make an efficient filtering of further defect types difficult and commercially not justifiable.

In view of the above, it is an object of the present invention to provide a method of forming a phase shift mask allowing for improved mask pattern inspection and wafer lithography. It is a further object of the invention to provide an alternating phase shift mask as well as a blank for fabricating a phase shift mask.

The invention is defined in independent claims 1, 16, 18.

According to the present invention, the above objects are achieved by a method of forming a phase shift mask comprising the steps of forming an absorber layer on a substrate, forming a protective layer on the absorber layer, forming and patterning a first mask structure on the protective layer, transferring the pattern of the first mask structure to the protective layer and the absorber layer by removing respective parts of said protective layer and said absorber layer, thereby uncovering at least part of the substrate by respective absorber layer openings, removing the first mask structure, forming and patterning a second mask structure on a surface of the at least partly uncovered substrate, forming substrate openings in regions that are not covered by the second mask structure and/or the stack of the absorber layer and the protective layer by removing respective parts of the substrate and removing said second mask structure and said protective layer. The second mask structure covers a first part of said aborber layer openings leaving a second part of said absorber layer openings uncovered. Thus, the substrate openings are merely formed congruent with the second part of said absorber layer openings. As a consequence, by means of said substrate openings, a phase shift is introduced for light passing the first part and the second part of the absorber layer openings. A depth of said substrate openings may be appropriately chosen to adjust a desired phase shift. This depth may be predetermined or it may even be adjusted in-situ during formation of said substrate openings. A typical phase shift introduced by said substrate openings equals 180°. However, said phase shift can be arbitrarily adjusted.

The substrate may be a quartz substrate or of any other material that, in case of transmissive phase shift masks, allows for transmission of the exposure wavelength. It is also possible that the substrate constitutes a reflective mask, e.g. an EUV (Extreme Ultra Violet) mask, comprising a multilayer stack on a base layer as a substrate. In this regard, such a substrate for an EUV mask may have a base layer of a near zero thermal expansion material such as ULE as well as a multilayer stack of Mo/Si formed thereon, for example. The first mask structure may be a resist that undergoes coating-, exposure- and development-steps, for example. However, many other materials may be used as a substrate for a reflective mask or as a first mask structure.

Removal of the first and/or the second mask structure may be carried out by a stripping process, for example. However, further removal processes can be carried out that allow for an appropriate selectivity to the material below the mask structure to be removed.

The transfer of the pattern of the first mask structure to the protective layer and the absorber layer as well as the formation of the substrate openings may be carried out by an etch process, for example.

The protective layer protects the absorber layer during removal of part of the substrate to form the substrate openings. Thus, an undesirable deterioration of the homogeneity of the absorber layer during this process step can be avoided.

Preferably, the substrate openings are formed by a removal process with a selectivity of material removal between the protective layer and the substrate of 1:x (x>0), whereas the protective layer is formed with a thickness larger than a depth of said substrate openings divided by the characteristic x. Thus, the formation of the substrate openings will not lead to a complete consumption of parts of the protective layer that are not covered by the second mask structure. Thus, this layer efficiently protects the absorber layer from any damage by the etch chemistry during formation of the substrate openings.

According to a preferred embodiment, said removal process is carried out by at least one of etch process and sputter process.

The removal of the protective layer can be carried out by e.g. a strip process with an appropriate selectivity to the absorber layer.

According to an embodiment of the invention, the absorber layer is formed as a single layer.

It is also preferable if said absorber layer further comprises a buffer layer. The buffer layer may be positioned between said multilayer stack and said absorber layer. The buffer layer may comprise at least one material of the group of SiO₂, Cr, CrN, for example. As a part of the absorber layer, the buffer layer is also removed by a patterning step in regions where said absorber layer openings are formed. Patterning the absorber layer and the buffer layer may be carried out by a common patterning step, e.g. a common etch step, or by subsequent different patterning steps, e.g. subsequent different etch steps.

According to a further preferred embodiment, the absorber layer is formed at least of a first light illumination absorbing layer and a second anti-reflection coating layer. The anti-reflection coating layer is beneficial in view of an improved defect inspection of optical masks, for example. The anti-reflection coating layer may also comprise several layers, whereas these layers preferably differ by their refractive indices to take advantage of interference effects for adjusting the reflection characteristics.

In a further preferred embodiment, the anti-reflection coating layer is formed as an oxide of a material of the absorber layer. For instance, when forming the absorber layer of an optical phase shift mask of chrome, the anti-reflection coating layer could comprise chrome oxide.

According to a further preferred embodiment of the invention, an auxiliary layer is directly formed on the absorber layer as a part of the protective layer. The auxiliary layer is positioned between the absorber layer and the further parts of the protective layer and is preferably chosen to improve the selectivity to the absorber layer during a final removal of the protective layer. The auxiliary layer is particularly useful in case that the selectivity between the further parts of the protective layer and the absorber layer during final removal of the protective layer would not be satisfactory, although these parts are well-suited with regard to the selectivity to the substrate when forming the substrate openings.

Preferably, the absorber layer comprises a metal and the removal process of forming the substrate openings is chosen such that the characteristic x is larger than 10. When fabricating optical phase shift masks using e.g. quartz substrates, the metal could be chosen as chrome, for example. Values of x larger than 10 constitute preferred values for fabricating optical phase shift masks.

Values of x larger than 5 may also serve as preferred values for fabricating EUV (Extreme Ultra Violet) phase shift masks.

It is particularly advantageous to carry out said removal process by an etch chemistry comprising fluorine.

In an advantageous embodiment, the absorber layer comprises at least one of the group consisting of Cr, TaN, Ti, TiN. In case of optical phase shift masks, it is particularly advantageous if said absorber layer comprises Cr. In case of EUV masks, the absorber layer preferably comprises at least one of the group consisting of TaN, Ti, TiN.

In a further advantageous embodiment, the protective layer comprises at least one of the group consisting of Cr, Al, AlN.

It is furthermore advantageous to form an auxiliary layer of SiO₂ below the protective layer in case said protective layer comprises Cr.

According to a further embodiment of the invention, the first mask structure is removed after its pattern is transferred to the protective layer, said protective layer providing a hardmask for removal of the respective parts of the absorber layer. Thus, the protective layer simultaneously acts as a hardmask in a first patterning step for patterning the absorber layer and as a protective layer in a second patterning step for forming the substrate openings to achieve the desired phase shift for light interference. When using the protective layer according to this embodiment, the protective layer will be chosen to provide an appropriate selectivity to the materials involved in both patterning processes. In this embodiment, a hardmask in the first patterning process serves as the protective layer in the second patterning process.

According to a preferred embodiment of the invention, there is provided an alternating phase shift mask, fabricated by a method according to the invention, comprising a stepless topography of an exposed surface of the absorber layer. Particularly, said stepless topography does not include edges introduced by removal of part of said absorber layer, e.g. by an etch process.

It is particularly advantageous, if said surface topography of the absorber layer is smaller than 1 nm.

According to a further preferred embodiment of the invention, an alternating phase shift mask is provided with a surface topography on top of the absorber layer of smaller than 1 nm. Such absorber layer topographies allow for an improved mask inspection process as well for improved wafer lithography.

A particularly advantageous embodiment of the invention provides a blank for fabricating a phase shift mask comprising a substrate, an absorber layer formed on a surface of said substrate and a protective layer formed on said absorber layer, said protective layer comprising a selectivity of material removal with regard to said substrate of at least 1:5. Considering suitable materials for said absorber layer and said protective layer, reference is taken to the above remarks addressing these elements.

It is to be understood that layer compositions as well as material compositions of said layers involved in the formation of said phase shift mask also hold true for said blank in case of their appearance.

It is furthermore advantageous, if said protective layer of said blank comprises a selectivity of material removal with regard to said absorber layer of at least 1:5. Thus, in later fabrication steps using said blank, the protective layer may simultaneously act as a hardmask in a first patterning process for patterning the absorber layer and as a protective layer in a second patterning process when forming substrate openings.

All different aspects of the present invention as set-out above and further elucidated below might be combined in any way. The accompanying drawings, which are incorporated in and constitute a part of the specification, illustrate exemplary embodiments of the invention and, together with a general description of the invention given above, and the detailed description of the exemplary embodiments given below, serve to explain the principles of the invention, wherein:
- Fig. 1a to 1g: show schematic cross-sections of subsequent method steps of forming a phase shift mask according to a first embodiment of the invention; and
- Fig. 2a to 2g: show schematic cross-sections of subsequent method steps of forming a phase shift mask according to a second embodiment of the invention.

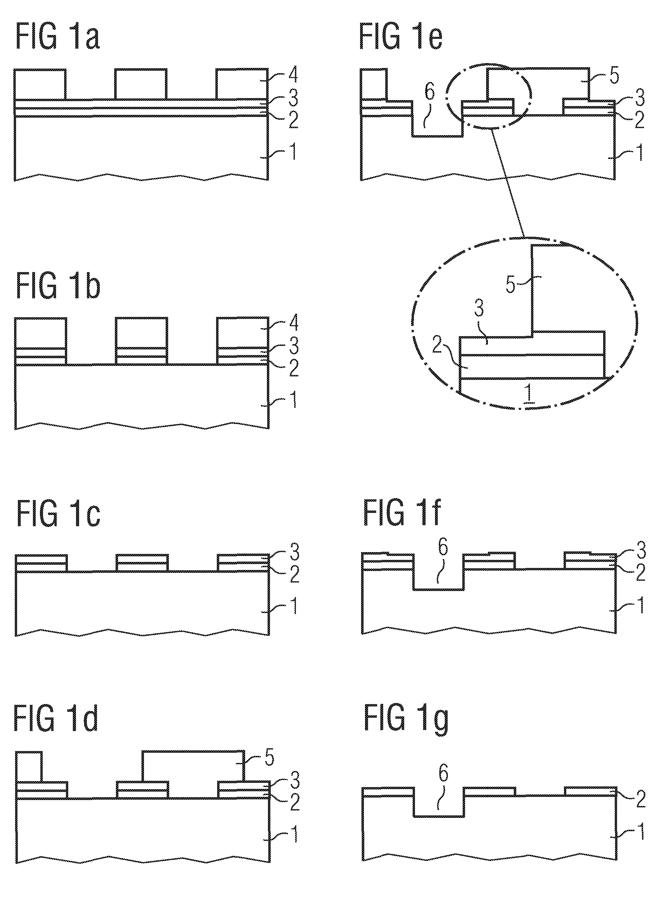

Fig. 1a shows a schematic cross-section of a method step at the beginning of the fabrication of an alternating optical phase shift mask according to a first embodiment of the invention. On a substrate 1 there is formed an absorber layer 2 with a protective layer 3 created above the absorber layer 2. A first mask structure 4, e.g. a resist, is formed on the protective layer 3. Patterning the protective layer 3 and the absorber layer 2 is considered as a first level patterning process.

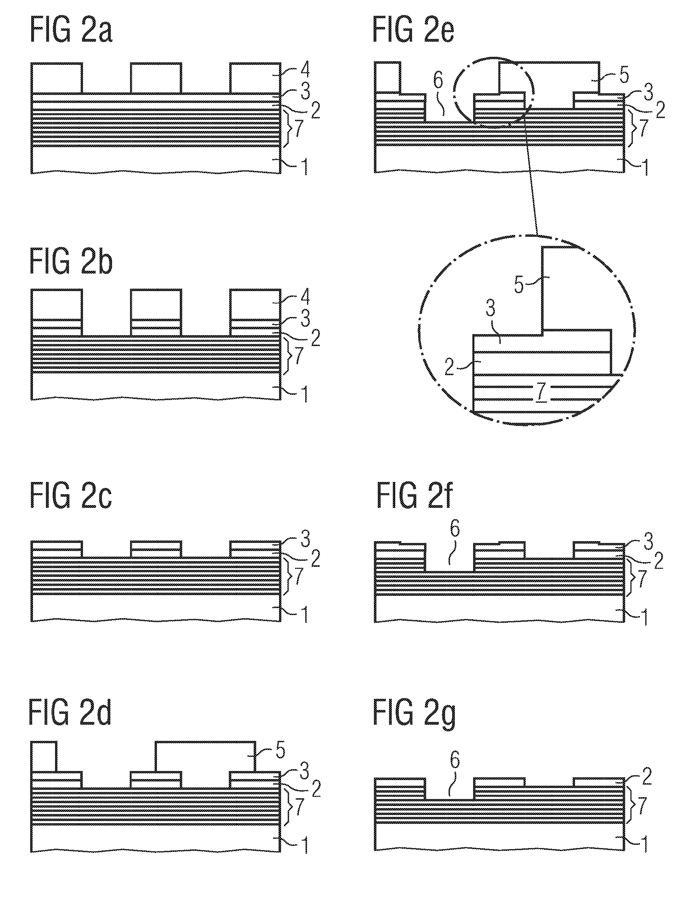

The method steps shown in Figs. 1a to 1g and also those shown in Figs. 2a to 2g merely constitute a small section of the substrate 1 comprising a single phase shift substrate opening 6 in order to improve clarity of the Figures and to avoid deflection to features that are not particularly relevant for understanding the invention. However, obviously, many substrate openings 6 may be provided within the substrate 1.

In a subsequent method step shown in Fig. 1b, the pattern of the first mask structure 4 is transferred to the protective layer 3 and the absorber layer 2 by removing respective parts thereof. Thus absorber layer openings are formed. The removal can be carried out e.g. by an etch process comprising a single etch step or subsequent etch steps with an appropriate selectivity to the material of the underlying substrate 1.

In a subsequent method step shown in Fig. 1c, the first mask structure 4 is removed, e.g. by a resist strip process.

In a subsequent method step that is schematically shown in Fig. 1d, a second mask structure 5 is formed on a surface of the at least partly uncovered substrate 1 to completely cover a part of the substrate openings in view of a subsequent patterning step. The second mask structure 5 partly covers the protective layer 3 and further completely covers a first absorber layer opening and leaves a second absorber layer opening completely uncovered. Due to a limited accuracy of overlay control between the absorber layer openings and the second mask structure the second mask structure cannot be adjusted congruent with a negative pattern of said second absorber layer opening or congruent with said first absorber layer opening. Thus, the protective layer 3 is partly involved to protect said absorber layer 2 in a subsequent method step introducing a substrate opening congruent with the second absorber layer opening.

This subsequent method step is shown Fig. 1e, wherein a substrate opening 6 is formed congruent with the second absorber layer opening. The formation of the substrate opening 6 may be carried out by an etch process, for example. During formation of the substrate opening 6, the protective layer 3 protects the absorber layer 2 from any damage, e.g. partial etch. Further insight into the protection of the absorber layer 2 can be gained from the magnified section of Fig. 1e. When forming the substrate opening 6, also uncovered parts of the protective layer 3 will be partly removed due to the finite etch selectivity of this method step with regard to the materials of the substrate 1 and the protective layer 3. Taking into account this finite selectivity, a thickness of the protective layer 3 can be properly chosen in order not to completely consume the uncovered parts of said protective layer 3 during the formation of the substrate opening 6. Thus, the protective layer 3 avoids any partial removal, e.g. a partial etch, of the absorber layer 2 during formation of the phase shift substrate opening 6. A desirable homogeneity of the absorber layer 2 can thus be maintained. A phase shift between two light paths traversing said first and second absorber layer openings, respectively, is introduced by an optical retardation due to a difference in refractive indices of said substrate opening 6 compared to a material of said substrate 1.

In a subsequent method step shown in Fig. 1f, the second mask structure 5 is removed, e.g. by a resist strip process.

After removal of the second mask structure 5, the protective layer 3 is removed to provide the alternating phase shift mask shown in Fig. 1g. Removal of the protective layer 3 is preferably carried out with a high selectivity to the absorber layer.

Figs. 2a to 2g provide schematic cross-sections of method steps of forming an alternating phase shift mask according to a second embodiment of the invention. The method steps carried out in Figs. 2a to 2g correspond, in principle, to the method steps carried out in Figs. 1a to 1g, respectively. Thus, reference is taken to the corresponding description parts above related to Figs. 1a to 1g.

However, the method according to this second embodiment of the invention differs from the abovementioned first embodiment in that the alternating phase shift masks fabricated by the method steps shown in Fig. 2a to Fig. 2g relate to an alternating EUV (Extreme Ultra Violet) phase shift mask. Therefore, the substrate 1 includes a multilayer stack 7 comprising an optional capping layer upmost onto which the absorber layer 3 is formed. The multilayer stack 7 allows to adjust the transmittance and reflectance of light by means of destructive or constructive interfence within the layers of the stack. Fractions of the exposure light wavelength are typically chosen as a thickness for each of the layers of the stack. Optionally, a buffer layer may be positioned between said multilayer stack 7 and said absorber layer 3 as part of said absorber layer 3. Contrary to the optical phase shift mask elucidated in Figs. 1a to 1g, EUV phase shift masks are realized as reflective masks due to the absorption of the exposure light within the substrate 1. A base layer of the substrate 1 may be of a near zero thermal expansion material, the multilayer stack 7 may be of Mo/Si with a metal absorber layer 3 formed thereon, for example. However, the above materials merely provide one possible example of a material choice for EUV phase shift masks. Many other materials may also be used to realize the substrate 1, the absorber layer 2, the protective layer 3 and the multilayer stack 7. These materials may be conductive, semi-conductive or insulating, for example.

Although embodiments of the present invention and its advantages have been described in detail, it should be understood that various changes, substitutions and alterations can be made herein without departing from the scope of the invention as defined by the appended claims. For example, it will be readily understood by those skilled in the art that the materials constituting the substrate, absorber layer, protective layer, first mask structure, second mask structure and multilayer stack herein may be varied while remaining within the scope of the present invention.

### List of reference symbols

- 1: substrate
- 2: absorber layer
- 3: protective layer
- 4: first mask structure
- 5: second mask structure
- 6: substrate opening
- 7: multilayer stack

## Claims

1. Method of forming a phase shift mask comprising the steps of:
- forming an absorber layer (2) on a substrate (1);
- forming a protective layer (3) on the absorber layer (2);
- forming and patterning a first mask structure (4) on the protective layer (3);
- transferring the pattern of the first mask structure (4) to the protective layer (3) and the absorber layer (2) by removing respective parts of said protective layer (3) and said absorber layer (2), thereby uncovering at least part of the substrate (1) by respective absorber layer openings;
- removing the first mask structure (4);
- forming and patterning a second mask structure (5) on a surface of the at least partly uncovered substrate (1);
- forming substrate openings (6) in regions that are not covered by the second mask structure (5) and/or the stack of the absorber layer (2) and the protective layer (3) by removing respective parts of the substrate (1); and
- removing said second mask structure (5) and said protective layer (3).

2. Method according to claim 1, wherein the absorber layer (2) is formed as a single layer.

3. Method according to claim 1, wherein the absorber layer (2) further comprises a buffer layer.

4. Method according to claim 3, wherein said buffer layer comprises at least one of the group consisting of SiO₂, Cr, CrN.

5. Method according to claim 1, 3 or 4, wherein the absorber layer (2) is formed at least of a first light illumination absorbing layer and a second anti-reflection coating layer thereon.

6. Method according to claim 5, wherein the anti-reflection coating layer is formed as an oxide of a material of the absorber layer (2).

7. Method according to any one of the preceding claims, comprising the further step of forming an auxiliary layer on the absorber layer (2) as part of the protective layer (3).

8. Method according to claim 7, wherein said auxiliary layer is formed of SiO₂ below the protective layer.

9. Method according to any one of the preceding claims, wherein:
- the substrate openings (6) are formed by a removal process having a selectivity of material removal between the protective layer (3) and the substrate (1) of 1:x (x>0); and
- the protective layer (3) is formed with a thickness being larger than a depth of said substrate openings (6) divided by x.

10. Method according to claim 9, wherein said removal process is carried out by at least one of etch process and sputter process.

11. Method according to claim 9 or 10, wherein the absorber layer (2) comprises a metal and the removal process for forming said substrate openings (6) is chosen such that x is larger than 5.

12. Method according to claim 9 or 10, wherein the absorber layer (2) comprises a metal and the removal process for forming said substrate openings (6)is chosen such that x is larger than 10.

13. Method according to any one of the preceding claims, wherein the absorber layer (2) comprises at least one of the group consisting of Cr, TaN, Ti, TiN.

14. Method according to any one of the preceding claims, wherein the protective layer (3) comprises at least one of the group consisting of Cr, A1, A1N.

15. Method according to any one of the preceding claims, wherein the first mask structure (4) is removed after its pattern is transferred to the protective layer (3), said protective layer (3) providing a hard mask for removal of the respective parts of the absorber layer (2).

16. Alternating phase shift mask, fabricated by a method according to any of the preceding claims, comprising a stepless topography of an exposed surface of the absorber layer (2).

17. Alternating phase shift mask according to claim 16, wherein said surface topography of the absorber layer (2) is smaller than 1 nm.

18. Blank for fabricating a phase shift mask comprising a substrate (1), an absorber layer (2) formed on a surface of said substrate (1) and a protective layer (3) formed on said absorber layer (2), said protective layer (3) comprising a selectivity of material removal with regard to said substrate (1) of at least 1:5.

19. Blank according to claim 18, wherein said protective layer (3) comprises a selectivity of material removal with regard to said absorber layer (2) of at least 1:5.
